# EUROPEAN PATENT APPLICATION

(11) **EP 0 791 965 A2**
(43) Date of publication of application: **27.08.1997**
(21) Application number: 97102755.2
(22) Date of filing: 20.02.1997
(51) Int. Cl.: H01L 29/78, H01L 29/10

(54) **Vertical four terminal transistor**

(30) Priority: 26.02.1996 US 606627
(71) Applicant: SILICONIX Incorporated, Santa Clara California 95054 (US)
(72) Inventor: Lui, Sik K., Sunnyvale, VA 94087 (US); Jew, Kevin, Fremont, CA 94539 (US)
(74) Representative: Kolb, Georg

(57) **Abstract**

A DMOS power transistor has: a source/drain terminal on a bottom surface of a wafer of a first conductivity type; a body region of a second conductivity type, in a top surface of the wafer; drain/source regions of the first conductivity type bounded laterally and from below by the body region; source/drain regions of the first conductivity type bounded laterally by the body region but in electrical contact with the source/drain terminal via a first conductivity type portion of the wafer; and a gate defining openings overlying the drain/source regions and openings overlying the source/drain regions. The gate's size controls channel lengths in the transistor so that channel lengths are insensitive to diffusion caused by thermal processes, and the transistor is easily fabricated on the same chip as other CMOS devices. Contacts for a drain/source terminal, a gate terminal, and a body terminal are formed from a single metal layer overlying the top surface of the wafer. Active regions of the power transistor are laid out in cells. In one embodiment, the drain/source regions are an array of uniformly spaced squares, and the source/drain regions are interspersed between the drain/source regions. The source/drain regions' widths are selected to minimize the resistance per area of the transistor and may be larger than the minimum design rule requirements.

## Description

### BACKGROUND OF THE INVENTION

### Field of the Invention

This invention relates to power transistors and methods for forming power transistors.

### Description of Related Art

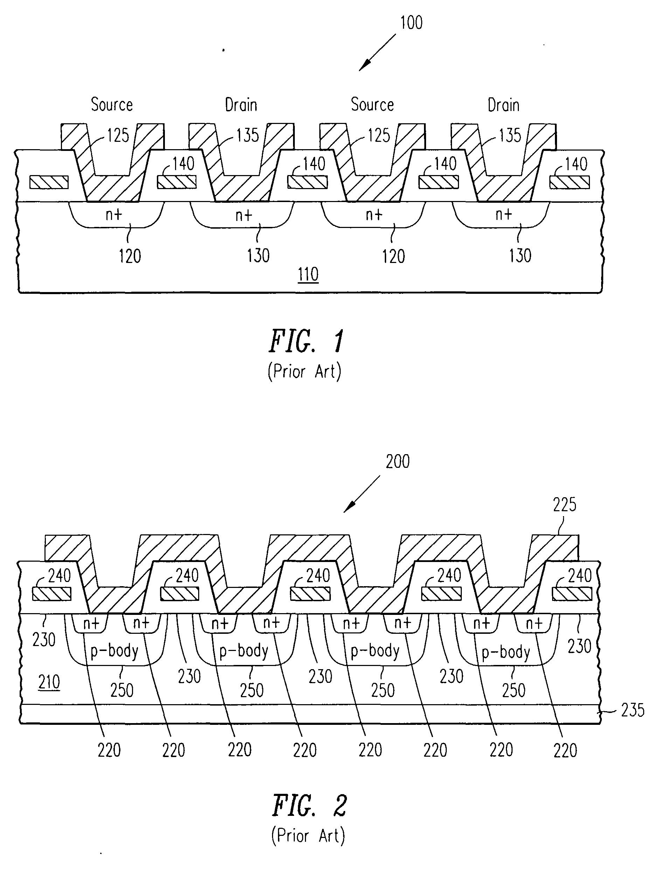

Power transistors often control relatively large currents and need to have low resistance and high heat dissipation. Fig. 1 shows a cross-sectional view of a portion of a conventional N channel field effect power transistor 100 capable of handling large current. Transistor 100 employs an array of source regions 120 and drain regions 130 formed in a semiconductor substrate 110 and an array of gates 140 overlying channels between the source and drain regions 120 and 130. A source terminal and contact 125 on a top surface of transistor 100 connects source regions 120 together. Similarly, a drain terminal and contact 135 on the top surface connects the drain regions 130 together. A gate terminal and contact 145 to gates 140 and a body terminal and contact (not shown) to the underlying substrate 110 are also on the top surface. Forming four terminals, source terminal 125, drain terminal 135, a gate terminal, and a body terminal, on the top surface of transistor 100 typically requires a process including formation of at least two metal layers. Typically, a metal layer which forms source and drain terminals 125 and 135 has at least two metal regions having interwoven features at the same scale as source and drain regions 120 and 130.

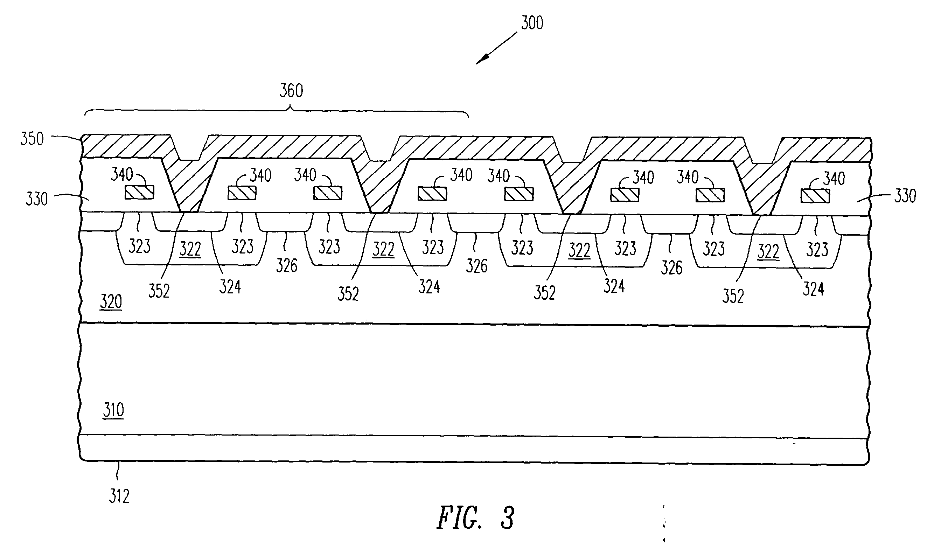

Fig. 2 shows a prior art three terminal N channel DMOS (double diffused metal oxide silicon) power transistor 200. Transistor 200 has N type source regions 220 formed in P type body regions 250 in an N type substrate 210. Gate regions 240 overlie drain regions 230 and channel regions at the edges of body regions 220. A drain terminal 235 on a bottom surface of substrate 210 is electrically connected to drain regions 230 via substrate 210. A source-body terminal 225 contacts both source regions 220 and body regions 250 from a top surface of transistor 200. Similarly, a gate terminal (not shown) contacts gate regions 240 from the top surface of transistor 200.

Unlike the terminals of transistor 100, the two terminals made on the top surface of transistor 200, source-body terminal 225 and the gate terminal, can be formed from a single metal layer, and typically source-body terminal 225 contains a relatively large unpatterned region. However, the voltages on source regions 220 and body regions 250 cannot be individually controlled, and transistor 200 can only control a current when the voltage on drain terminal 235 is higher than the voltage on source-body terminal 225. Because the higher voltage on drain terminal 235 is applied to substrate 210, turning transistor 200 on and off can cause voltage fluctuations in substrate 210 that interfere with the operation of other CMOS devices (not shown) formed in substrate 210. Another disadvantage of transistor 200 is that its channel lengths depend on the extent of body regions 250 under gate 240 and are controlled by diffusion of dopants from body regions 250. If other CMOS devices are formed in substrate 210 with DMOS transistor 200, thermal processes used to form DMOS transistor 200 cause diffusion and make process control for the other CMOS devices more difficult.

A power transistor is needed that only requires a single metal layer for terminals on a top surface, permits independent control of source and body voltages for bi-directional switching, and is compatible with processes for forming CMOS devices in the same substrate as the power transistor.

### SUMMARY OF THE INVENTION

In accordance with an embodiment of this invention, a four terminal double diffused power transistor has a drain/source terminal, a gate terminal, and a body terminal on a top surface and has a source/drain terminal on a bottom surface. The power transistor is formed in a semiconductor wafer of a first conductivity type having a patterned body region of a second conductivity type which encompasses source/drain regions of the first conductivity type. The source/drain regions are in electrical contact with the source/drain terminal through the wafer. A patterned gate overlies channel regions in the body region. The gate is used during fabrication as a mask for formation of source/drain regions and drain/source regions. The size and shape of the gate determine the channel lengths of the transistor. Accordingly, the transistor is tolerant of thermal CMOS fabrication processes which cause diffusion.

The active regions of the power transistor are typically arranged in cells, each cell conducting current in parallel with the other cells. Contacts for the drain/source terminal on the top surface of the wafer are formed from a metal layer overlying the cells and in contact with the drain/source regions of each cell but not in contact with the body region. Contacts for the gate terminal and the body terminal are outside the perimeter of the cells and formed from the same metal layer as the drain/source terminal.

Another embodiment of this invention is a transistor formed in and on a semiconductor wafer of a first conductivity type. The transistor has: a source/drain terminal on the bottom surface of the wafer; a body region of a second conductivity type, in the top surface of the wafer; drain/source regions of the first conductivity type bounded laterally and from below by the body region; source/drain regions of the first conductivity type bounded laterally by the body region but in electrical contact with the source/drain terminal via a first conductivity type portion of the wafer; and a gate having openings overlying the drain/source regions and openings overlying of source/drain regions.

Typically, the wafer is a semiconductor substrate having an epitaxial layer formed on the substrate's top surface, and the body region, the source/drain regions, and the drain/source regions are in the epitaxial layer. The source/drain region may also include a lightly doped portion to prevent punch through when a high voltage is applied.

An insulating layer overlying the gate and wafer has openings to an area completely inside a boundary of the drain/source regions. Contacts to the drain/source regions are disposed in the openings. Contacts to the body region and gate are outside the active area of the transistor. The transistor provides separate control of the voltage on the body region and the voltage on the drain/source region for bi-directional switching.

In another embodiment of this invention, the drain/source regions are an array of uniformly spaced square regions, and the source/drain regions are interspersed between the drain/source regions. The source/drain regions' widths may be selected to minimize the resistance per area of the transistor. Still another embodiment of this invention is an integrated circuit including CMOS devices such as N or P channel transistors formed in and on a wafer containing a power transistor in accordance with any of the above disclosed embodiments.

### BRIEF DESCRIPTION OF THE DRAWINGS

Fig. 1 shows a cross-sectional view of a prior art four terminal power transistor.

Fig. 2 shows a cross-sectional view of a prior art three terminal power transistor.

Fig. 3 shows a cross-sectional view of a portion of a four terminal power transistor in accordance with an embodiment of this invention.

Fig. 4 shows a plan view of a portion of the power transistor of Fig. 3.

Fig. 5 shows a cross-sectional view of an integrated circuit in accordance with an embodiment of this invention.

Figs. 6A, 6B, and 6C show cross-sectional views of structures formed during a process for making the integrated circuit of Fig. 5.

Figs. 7, 8, 9, and 10 illustrate different configurations of lightly doped drift regions in transistors in accordance with embodiments of this invention.

Fig. 11 shows plots of resistance per area verses poly spacing for transistors in accordance with the embodiments of Fig. 10.

Use of the same reference symbols in different figures indicates similar or identical items.

### DETAILED DESCRIPTION OF THE INVENTION

An embodiment of this invention, shown in Fig. 3, provides a compact, four-terminal N channel DMOS field effect power transistor 300. Transistor 300 is compatible with CMOS processes so that transistor 300 and other CMOS devices are easily combined in a single integrated circuit formed in and on a substrate 310 and an epitaxial layer 320. In particular, transistor 300 tolerates thermal processes during formation of CMOS devices because the width of gate regions 340 and not diffusion controls the channel lengths in transistor 300.

Transistor 300 has four terminals: a gate terminal (not shown) connected to gates 340, a drain/source terminal 350, a source/drain terminal 312, and a body terminal (not shown). (The term drain/source as used herein indicates a structure usable either as a drain or as a source. The term source/drain indicates a complementary structure to a drain/source.) Drain/source terminal 350 contacts drain/source regions 324 in areas 352 without contacting body regions 322, so that the voltage on drain/source regions 324 and the voltage on body regions 322 are independently controllable. Accordingly, if the voltage on body regions 322 is properly selected, body regions 322 can isolate drain/source regions 324 when drain/source regions 324 are the drain or the source of transistor 300. Coupling drain/source regions 324 to a supply voltage and source/drain terminal 312 to ground reduces the effect that transistor 300 has on other devices formed in and on substrate 310 because substrate 310 when grounded is less subject to voltage fluctuations caused by switching of transistor 300.

Current flows between source/drain regions 326 and source/drain contact 312 through epitaxial layer 320 and substrate 310. Source/drain regions 326, epitaxial layer 320, and substrate 310 all contain the same type of dopants, (N type) so that current is not restricted by semiconductor junctions. The resistance between each source/drain region 326 and source/drain contact 312 depends on the effective dopant concentrations of epitaxial layer 320 and substrate 310, the thicknesses of epitaxial layer 320 (typically between about 3 and about 5 µm) and substrate 310 (typically between about 280 µm and about 360 µm after packaging), and the cross-sectional area along the current path to source/drain terminal 312. Epitaxial layer 320 typically has the smallest effective dopant concentration and provides the greatest contribution to the resistance. As disclosed below, the area of source/drain regions 326 can be selected to minimize the resistance per area of power transistor 300.

Gate regions 340 overlie channel regions 323 in body regions 322 and are electrically isolated from body regions 322 and drain/source terminal 350 by an insulator 330 which is typically silicon dioxide. The gate and body terminals are formed around the perimeter of the active regions of transistor 300 and are not shown in Fig. 3.

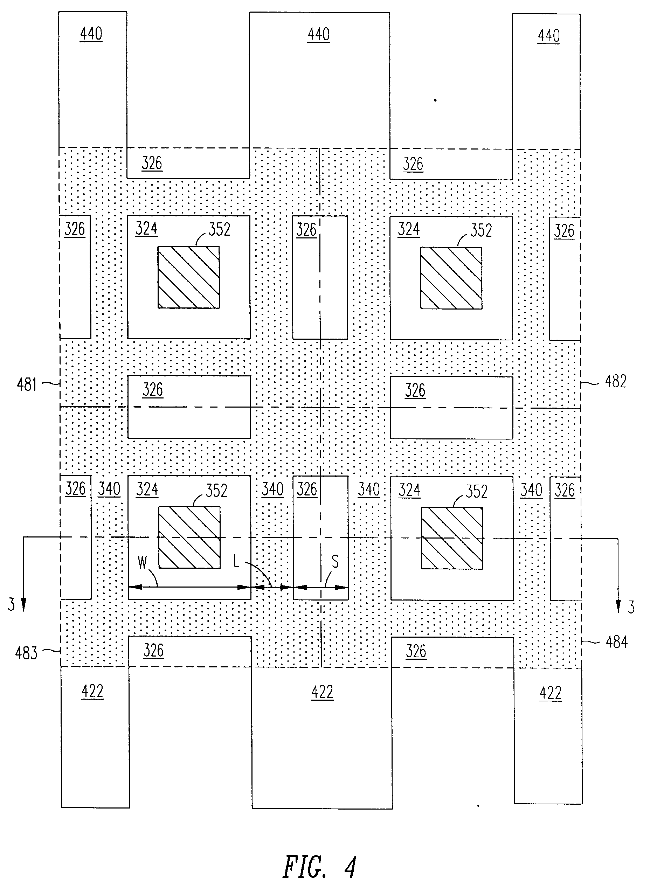

Fig. 4 shows a plan view of a portion of the top surface of power transistor 300. Cross-section line 3-3 in Fig. 4 indicates a portion 360 of the cross-sectional view shown in Fig. 3. Fig. 4 shows four identical cells 481 to 484 (indicated by dotted lines) which show the layout of active regions in transistor 300. A typical power transistor might contain thousands or millions of such cells. The dimensions of cells 481 to 484 are selected for the desired performance and manufacturing tolerances of transistor 300. Drain/source regions 324 are separated from each other in epitaxial layer 320 but coupled together by drain/source terminal 350. Areas 352 indicate where drain/source terminal 350 contacts underlying drain/source regions 324. Drain/source terminal 350 is formed as a metal layer covering cells 481 to 484 and contacting areas 352 through openings in insulator 330. Source/drain regions 326 are separated laterally from each other in epitaxial layer 320, but are electrically coupled together though underlying portions of epitaxial layer 320, substrate 310, and source/drain terminal 312.

Gate regions 340 are parts of a patterned grid of a conductive material such as doped polycrystalline silicon. The grid of gate regions 340 contains openings for formation of drain/source regions 324 and source/drain regions 326 and for contacts of drain/source terminal 350. The openings are separated by a width L of gate regions 340. Width L controls the channel lengths of the cells of transistor 300, and since shorter channel lengths reduce resistance of transistor 300, width L is typically the minimum width permitted by lithography and the design rules employed in fabrication of transistor 300. A width W of drain/source regions 324 is larger than the minimum opening size of contact area 352 by enough that drain/source contact 350 do not contact gate regions 340 after expected misalignment between a mask that defines gate regions 340 and a mask that defines openings to areas 352. Openings for source/drain regions 326 have a width S. Width S is limited by lithography and design rules, but as disclosed in more detail below, to minimize resistance per area of transistor 300, width S may be larger than the design rule limit.

The conductive material of gate regions 340 extends into regions 440 beyond the perimeter of cells 481 to 484. A gate terminal (not shown) contacts conductive regions 440 beyond the perimeter of drain/source contact 350 and may be formed from the metal layer that forms drain/source contact 350. Body regions 322 are not shown in Fig. 4 but are parts of an electrically connected grid formed in the epitaxial layer underlying gate regions 340 and drain/source regions 324. The doping pattern which forms the grid containing body regions 322 extends beyond the perimeter of cells 481, 482, 483, and 484 to regions 422. The body terminal (not shown) contacts regions 422 beyond the perimeter of drain/source contact 350 and may be formed from the same layer that forms drain/source terminal 350 and the gate terminal.

Fig. 4 shows regions 440 which contact the gate terminal on a side of cells 481 to 484 opposite from a side on which regions 422 contact the body terminal. Many other configurations are possible including, for example, forming both the gate terminal and the body terminal on the same side of cells 481 to 484 and/or forming a plurality of gate and body terminals around the perimeter of cells 481 to 484.

Source/drain terminal 312 is on a bottom surface of semiconductor substrate 310. Drain/source terminal 350, a body terminal (not shown) for body (P-well) regions 322, and a gate terminal (not shown) for gate regions 340 are on a top surface of transistor 300. A single metal layer is sufficient for the terminals on the top surface. Additionally, drain/source terminal 350 can be a large unpatterned region overlying the active regions of transistor 300. Accordingly, forming terminals and contacts for transistor 300 is less complex and less expensive than is the case in four terminal power transistors that require two interwoven patterned metal regions for source and drain contacts.

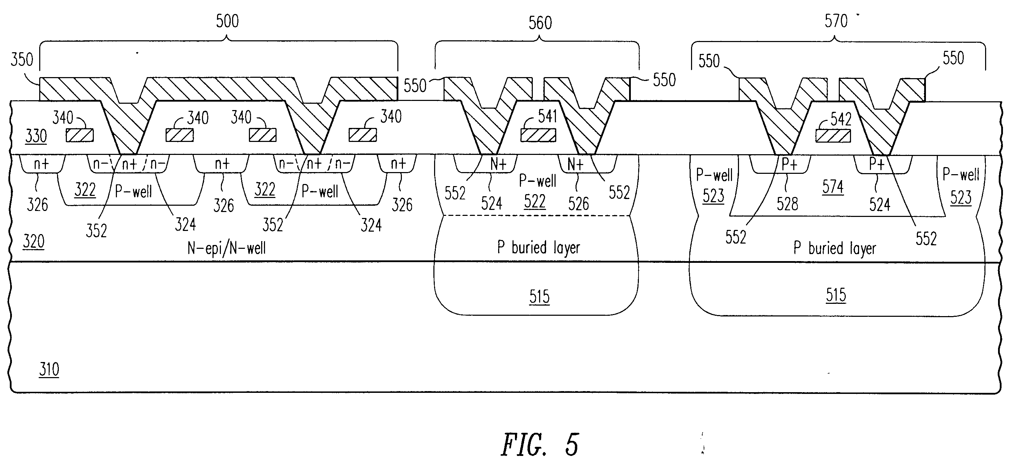

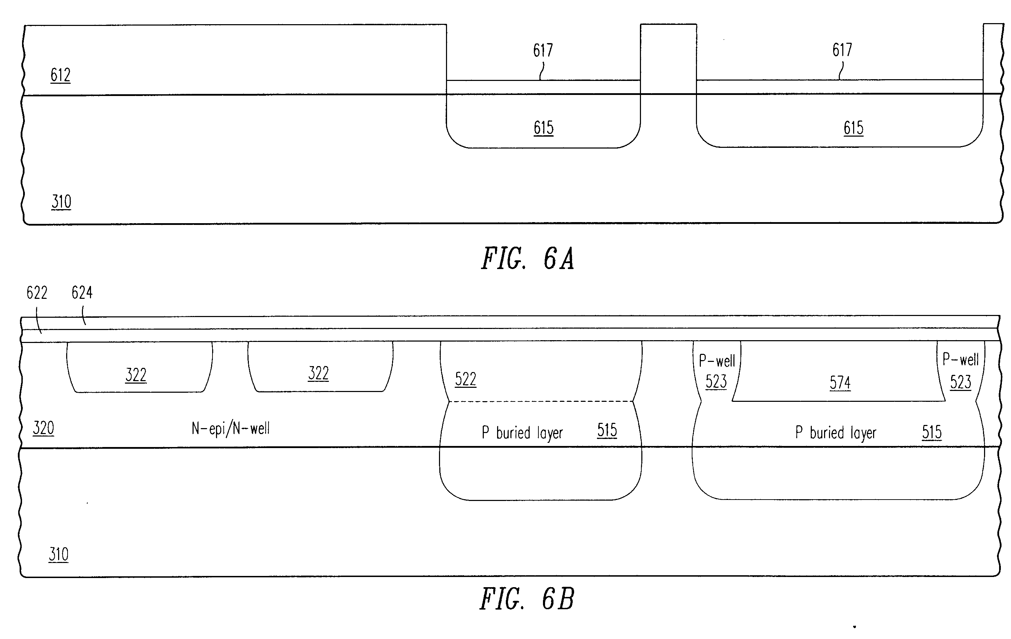

Fig. 5 shows an example of an integrated circuit in accordance with an embodiment of this invention. The integrated circuit includes a power transistor 500, an NMOS transistor 560, and a PMOS transistor 570. Power transistor 500 contains elements having the same reference symbols as elements of power transistor 300, and the above description of those elements also applies to transistor 500. NMOS transistor 560 and PMOS transistor 570 are examples of typical CMOS devices formed in and on substrate 310. Typically, CMOS devices such as transistors 560 and 570 are part of a circuit such as a control logic circuit for controlling power transistor 500 or a circuit which uses the power provided through power transistor 500. Power transistor 500 and CMOS devices 560 and 570 may be formed using a process as described below and illustrated in Figs. 6A to 6C.

Substrate 310 shown in Fig. 6A is monocrystalline silicon with an N+ doping of a dopant such as phosphorous or arsenic to provide a resistivity of about 3 to 5 mΩ·cm and is initially between about 500 µm and 700 µm thick. Conventional techniques form a silicon dioxide layer 612 to about 5000 Å thick on substrate 310. Layer 612 is masked and etched to form a silicon dioxide mask for forming P buried regions 615 in substrate 310. Conventional doping techniques such as ion plantation with boron at a dose of about 1x10¹⁴ cm⁻² at 100 KeV form initial P buried regions 615 with depth of about 3000 Å. A screen oxidation layer 617 may be grown to a thickness of about 300 to 500 Å to protect substrate 310 from damage during the ion implantation.

After implantation of P buried regions 615, silicon dioxide layers 612 and 617 are removed and epitaxial layer 320 of monocrystalline silicon about 3 to 5 µm thick is grown using conventional chemical vapor deposition techniques as in Fig. 6B. Epitaxial layer 320 has a dopant concentration between about 1x10¹⁶ and 3x10¹⁶ cm⁻³ of an N type dopant such as phosphorous or arsenic.

Epitaxial layer 320 is masked for formation of P-wells 522, twin-wells 523, and body regions 322. For double implanted twin-wells, an approximately 400 Å thick pad silicon dioxide layer 622 and an approximately 1800 Å thick silicon nitride layer 624 are formed on epitaxial layer 320 as shown in Fig. 6B. Conventional photoresist patterning and plasma etching selectively remove silicon nitride layer 624 from over regions where the P-well regions 322, 522, and 523, and a P type dopant such as boron is implanted through layer 622. A thermal process at about 1100 °C for 300 minutes drives in the implanted P-wells 322, 522, and 523 and grows a thick oxide layer over the p-well regions. The silicon nitride masks part of the surface so that no oxide grows in the regions covered by nitride. The silicon nitride is then removed typically in a wet phosphoric acid solution to leave thick oxide regions over P-well regions 322, 522, and 523 and oxide layer 622 over the rest of epitaxial layer 320. An N type dopant such as phosphorous is implanted through layer 622 to form N-well regions while the thick oxide protects P-wells 322, 522, and 523 from the N type dopants. During the P-well drive-in processes, dopants from buried regions 615 in substrate 310 diffuse upwards into epitaxial layer 320 to form buried regions 515. P-wells 523 and one of buried regions 515 surround and electrically isolate an N-well 574 of N doped silicon in which PMOS transistor 570 is formed.

An approximately 400 Å thick silicon dioxide pad layer and an approximately 1800 Å thick silicon nitride layer are again formed on epitaxial layer 320. The nitride layer is patterned to form a nitride mask for field oxidation, and field oxidation (not shown) is grown in the openings of the nitride mask. The silicon nitride and silicon dioxide layers are stripped from epitaxial layer 320 leaving the field oxide. A layer of sacrificial oxide for threshold (or VT) implants is formed. Threshold implants are conventional and adjust the effective dopant concentrations in body regions 322, P-well 522, and N-well 574 so that transistors 500, 560, and 570 respectively have the desired threshold voltages.

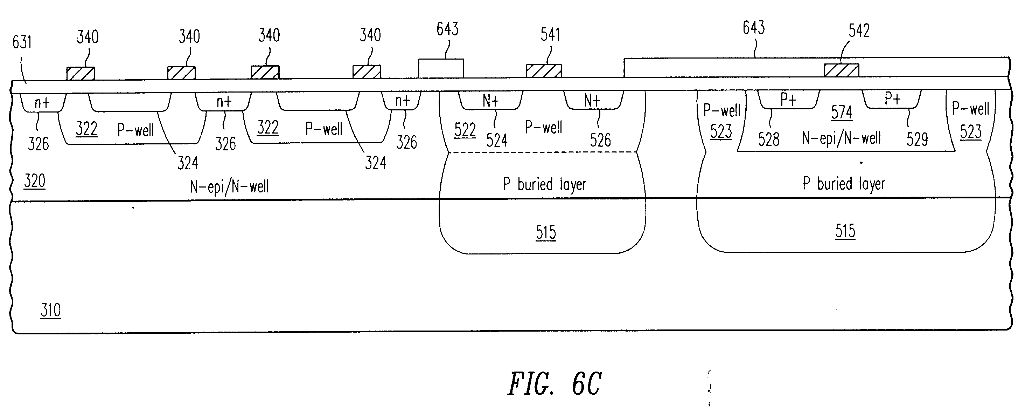

As shown in Fig. 6C, a gate oxide layer 631 between about 150 Å and about 200 Å thick is grown or deposited on epitaxial layer 320. A polysilicon layer deposited on gate oxide layer 631 is doped to a resistance of about 20 Ω/square. Conventional masking and etching of the polysilicon layer forms polysilicon regions such as gate regions 340, 541, and 542, bonding pads (not shown) for gate contacts, and polysilicon interconnects (not shown). Reoxidation forms a thin layer of oxide on the polysilicon regions.

A layer of photoresist is formed over gate oxide layer 631 then conventionally patterned to form photoresist regions 643 as shown in Fig. 6C. Photoresist regions 643 and gate regions 340 and 541 form a mask for formation of N type regions 324, 326, 524, and 526. P type source and drain regions 528 and 529 are formed using a second mask (not shown) that includes photoresist regions (not shown) and gate 542. With this method, regions 324, 326, 524, 526, 528, and 529 are self aligned to gate regions 340, 541, and 542, and the channel regions of transistors 500, 560, and 570 have lengths defined by the widths of gates 340, 541, and 542 respectively. Formation of any of regions 324, 326, 524, 526, 528, and 529 may proceed using more than one mask to define lightly doped drift regions for improved breakdown characteristics at higher voltages. Techniques for forming light doped drift regions in the drains of field effect transistors (FETs) are well known and commonly employed in forming FETs that handle high voltages. Embodiments of this invention employing drift regions are described in more detail below.

After formation of source and drain regions, an insulator such as a layer of boron-phosphorous-silicate glass (BPSG) is deposited and etched to provide openings to areas 352 and 552 (see Fig. 5) for contacts. A metal layer is then deposited and etched to form drain/source terminal 350, the gate terminal (not shown), and the body terminals (not show) for power transistor 500 and terminals 550 for transistors 560 and 570. Conventional finishing and packaging of the integrated circuit reduces the thickness of substrate 310 to between about 280 µm and about 360 µm.

With the above process, the width of gate regions 340 define the channel lengths in power transistor 500. Power transistor 500 is more tolerant of thermal processes than are transistors formed using diffusion to define channel lengths. Accordingly, power transistor 500 is more easily manufactured on the same chip with a CMOS circuit.

As will be appreciated by those skilled in the art, the above process may be altered in a variety of ways. Alternative semiconductor materials such as gallium arsenide or polycrystalline silicon may be used in place of monocrystalline silicon. Doping types, species, and concentrations can also be changed. Additionally, the order of the process steps may be varied, and many alternative techniques for forming layers, masking, etching, and doping layers may be used in the above-disclosed process.

As mentioned above, lightly doped drift regions decrease the chance of punch through in high voltage applications of transistors in accordance with this invention. A disadvantage of drift regions is that they increase the resistance of the transistor. In transistors for switching a current having a constant direction, where the higher voltage is always applied to the same terminal, the drain terminal has a lightly doped drift region. Typically, the source does not require a drift region because when the transistor is off, the largest voltage drop is on the drain side of the transistor. For high voltage bi-directional switching, both the source/drain and the drain/source regions have lightly doped drift regions.

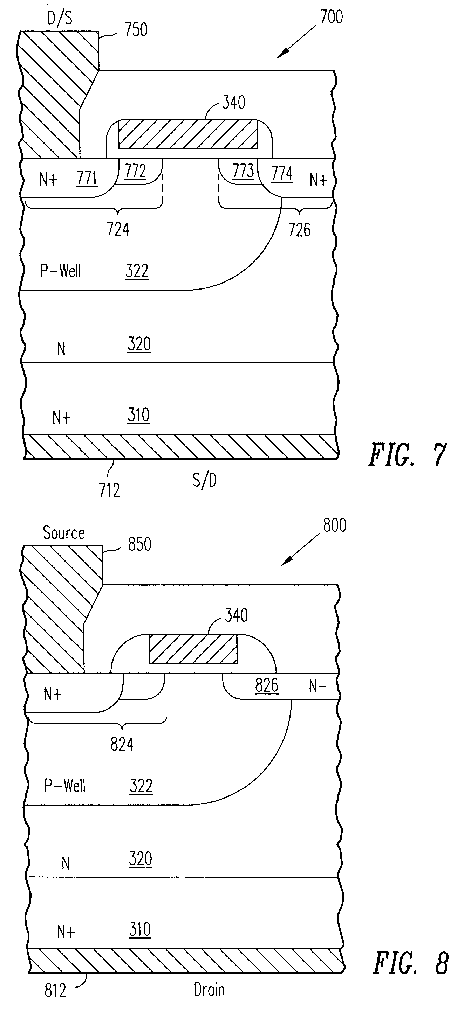

Fig. 7 shows a drain/source region 724 and a source/drain region 726 in an NMOS power transistor 700 for bi-directional switching of a 5 volt potential. Either a drain/source terminal 350 or a source/drain terminal 312 may be the drain of transistor 700 depending on which terminal 350 or 312 is connected to a higher voltage. In the embodiment of Fig. 7, each drain/source region 724 has an N+ region 771 and an N- region 772. N+ region 771 has a dopant concentration of about 10²⁰ cm⁻³. N- region 772 is a short (about 0.25 µm) drift region that has a dopant concentration of about 10¹⁷ to 10¹⁸ cm⁻³ and is formed by diffusion from N+ region 771. N- region 772 decreases the peak electric field in transistor 700 by spreading a voltage drop across the length of N- region 772 when transistor 700 is off. Similarly, source/drain region 726 contains an N- region 773 with length of about 0.25 µm and dopant concentration between about 10¹⁷ and 10¹⁸ cm⁻³.

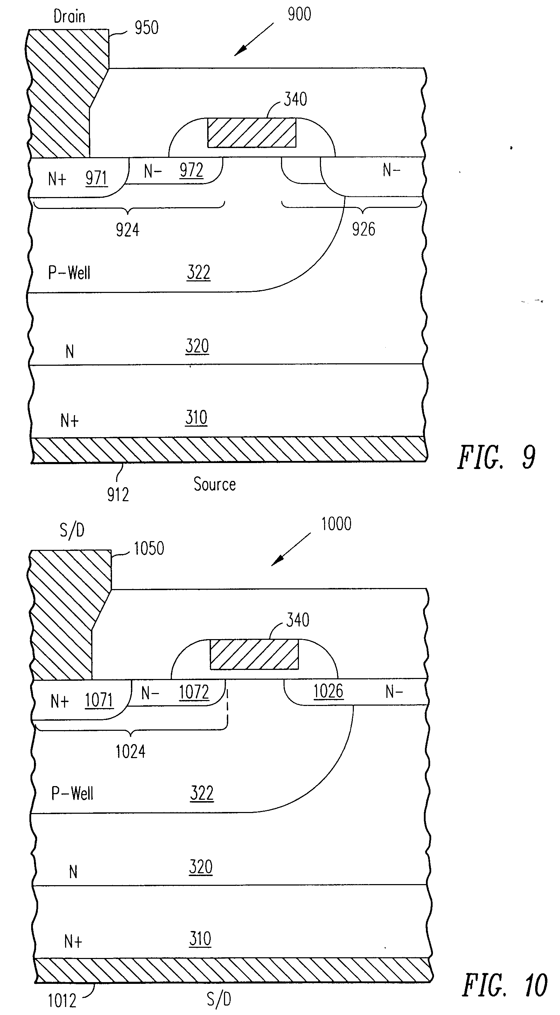

Fig. 8 shows a source region 824 and an N- drain region 826 in an NMOS power transistor 800 for switching of a 12 volt potential. In a typical application of transistor 800, a supply voltage (12 volts) is placed on a drain terminal 812 at the bottom surface of substrate 310, and a source terminal 850 is grounded (0 volts). Source region 824 is the same as drain/source region 724 described above in regard to Fig. 7. N- drain region 826 has an effective dopant concentration of about 10¹⁷ to 10¹⁸ cm⁻³ and is formed using multiple masks and implants. In particular, a photoresist mask protects region 826 during formation of an N+ region in source 824.

N- drain region 826 and epitaxial layer 320 act as a lightly doped drift region which reduces the electric field near gate 340 by distributing the voltage difference between gate 340 and drain terminal 812 across the length of N- drain region 825 and the thickness of epitaxial. This helps to prevent punch through. The thickness of the epitaxial layer or distance from the edge of P-well 322 to the edge of gate 340 can be increased to for transistors used at higher voltage.

Fig. 9 shows a source region 926 and a drain region 924 in another NMOS power transistor 900 for switching of a 12 volt potential. In typical application of transistor 900, the supply voltage is placed on drain terminal 950 at the top surface of transistor 900, and source terminal 912 is grounded. A source region 926 is the same as drain/source region 724 described above in regard to Fig. 7. A drain region 924 includes an N+ region 971 and an N- lightly doped drift region 972. N+ region 971 has a dopant concentration of about 10²⁰. N- region 972 has a dopant concentration of about 10¹⁷ to 10¹⁸ and a length of 1 to 2 µm from region 971 to a point underlying gate 340. A longer drift region may be employed to increase resistance to punch through for higher voltage applications. Transistor 900 has the advantage that substrate 310 is kept at ground so that operation of power transistor 900 disturbs the substrate voltage less than does operation transistor 800 in Fig. 8. A disadvantage of the embodiment of Fig. 9 is that source region 924 is longer than drain region 824 of Fig. 8, so that transistor 900 requires more area than does transistor 800 for the same resistance.

Fig. 10 shows a drain/source region 1024 and a source/drain region 1026 in an NMOS power transistor 1000 for bi-directional switching of a 12 volt potential. In the embodiment of Fig. 10, the supply voltage may be placed on either drain/source terminal 1050 at the top surface of transistor 1000 or source/drain terminal 1012 at the bottom surface of substrate 310. An N+ region 1071 and an N- drift regions 1026 and 1072 have dopant concentrations of about 10²⁰ cm⁻³ and about 10¹⁷ to 10¹⁸ cm⁻³ respectively. N- drift regions 1072 have lengths of 1 to 2 µm from N+ region 1071 to a point under an edge of gate 340. The portion of source/drain region 1026 between the edge of gate 340 and the edge of P-well 322 is about 1 to 2 µm.

The embodiments of this invention may have regions as shown in cross-section in Figs. 7, 8, 9, and 10 laid out as shown in Fig. 4. In such embodiments, regions 726, 826, 926, and 1026 of Figs. 7, 8, 9, and 10 have widths S as shown in Fig. 4. Width S is sometimes referred to herein as the "poly spacing" of the transistor. Making the poly spacing larger reduces the resistance per cell in a transistor because larger poly spacing provides a larger current path between region 726, 826, 926, or 1026 and the underlying transistor terminal 712, 812, 912, or 1012 respectively. However, increasing the poly spacing also increases the area of the cell so that fewer cells fit in a given area of transistor. A poly spacing may be selected so that the resistance per area is at a minimum.

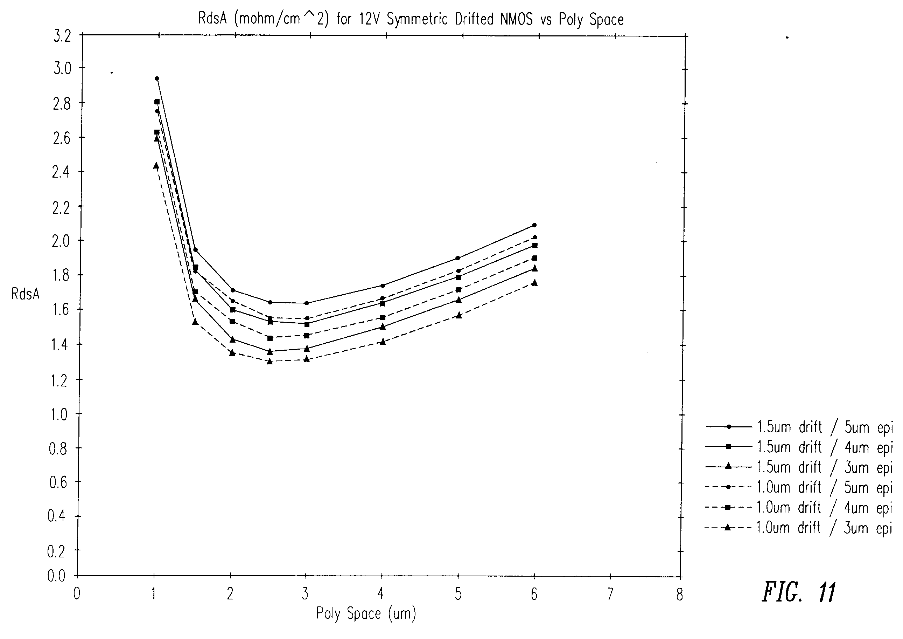

Fig. 11 shows plots of resistance per area (RdsA) verses poly spacing for transistors according to the embodiment of Fig. 10 when laid out as shown in Fig. 4. The plots in Figs. 11 are theoretical and assume epitaxial layer 320 has a resistivity of 0.5 Ω·cm and 1 µm design rules. Based on 1 µm design rules, width W (the width of region 1024) is about 2.5 µm, and width L of the gate region 340 is about 1 µm (the minimum process dimension). As shown in Fig. 11, the minimum resistance per area of transistor 100 occurs for poly spacing S larger than the design rule limit. For example, for a 1 µm long drift region 1072 and a 4 µm thick epitaxial layer 320, the poly spacing S which minimizes transistor resistance is about 2.5 µm. The optimal poly spacing S for minimizing resistance of transistor of the embodiments of Figs. 7, 8, and 9 may be determined similarly.

Although the present invention has been described with reference to particular embodiments, the description is only an example of the invention's application and should not be taken as a limitation. In particular, even though much of preceding disclosure described NMOS power transistors, alternative embodiments of this invention include PMOS power transistors. Various other adaptations and combinations of features of the embodiments disclosed are within the scope of the present invention as defined by the following claims.

## Claims

1. A transistor comprising:
a semiconductor wafer of a first conductivity type, the semiconductor wafer having a bottom surface and a top surface;
a source/drain terminal on the bottom surface of the wafer;
a body region of a second conductivity type disposed in the top surface of the wafer;
a plurality of drain/source regions of the first conductivity type in the wafer, wherein each drain/source region is bounded laterally and from below by the body region;
a plurality of source/drain regions of the first conductivity type in the wafer, wherein each source/drain region is bounded laterally by the body region and is in electrical contact with the source/drain terminal via a first conductivity type portion of the wafer; and
a gate overlying the wafer, the gate defining openings overlying the drain/source regions and openings overlying the source/drain regions.

2. The transistor of claim 1, wherein the wafer comprises:
a substrate of the first conductivity type; and
an epitaxial layer of the first conductivity type, formed on a top surface of the substrate, wherein the body region, the source/drain regions, and the drain/source regions are in the epitaxial layer.

3. The transistor of claim 2, wherein the drain/source regions have an effective dopant concentration higher than a dopant concentration of the epitaxial layer.

4. The transistor of claim 2, further comprising:
an insulator which electrically isolates the gate from underlying portions of the epitaxial layer, the insulator defining a first set of openings to portions of the drain/source regions; and
a first conducting region which overlies the insulator, makes electrical contact with the drain/source regions through the first set of openings, and is electrically isolated from the body region.

5. The transistor of claim 4, wherein the insulator defines a second set of openings, and the transistor further comprises a second conducting region overlying the insulator and laterally spaced apart from the first conducting region, the second conducting region making electrical contact with the gate through the second set of openings.

6. The transistor of claim 5, wherein the insulator defines a third set of openings, and the transistor further comprises a third conducting region overlying the insulator and laterally spaced apart from the first and second conducting regions, the third conducting region making electrical contact with the body region through the third set of openings.

7. The transistor of claim 5, wherein each of the drain/source regions includes a lightly doped region proximate to a nearest portion of the gate.

8. The transistor of claim 2, wherein each of the drain/source regions includes a lightly doped region proximate to a nearest portion of the gate.

9. The transistor of claim 1, wherein the drain/source regions comprise an array of uniformly spaced apart square regions at a top surface of the wafer.

10. The transistor of claim 9, wherein the source/drain regions comprise rectangular regions interspersed between the drain/source regions at a top surface of the wafer, wherein each source/drain region has two sides about equal in length to a side of the drain/source regions.

11. The transistor of claim 10, wherein:
the drain/source regions are spaced apart by a distance equal to the sum of a first and a second gate width and a width of one of the source/drain regions; and
the width of each source/drain region is such that a resistance per area of the transistor is at a minimum.

12. The transistor of claim 1, wherein:
the drain/source regions are spaced apart by a distance equal to the sum of a first and a second gate width and a width of one of the source/drain regions; and
the width of each source/drain region is such that a resistance per area of the transistor is at a minimum.

13. An integrated circuit comprising a power transistor, wherein the power transistor comprises:
a semiconductor wafer of a first conductivity type, the semiconductor wafer having a bottom surface and a top surface;
a source/drain terminal on the bottom surface of the wafer;
a body region of a second conductivity type disposed in the top surface of the wafer;
a plurality of drain/source regions of the first conductivity type formed in the wafer, wherein each drain/source region is bounded laterally and from below by the body region;
a plurality of source/drain regions of the first conductivity type formed in the wafer, wherein each source/drain region is bounded laterally by the body region and is in electrical contact with the source/drain terminal via a first conductivity type portion of the wafer; and
a gate overlying the wafer, the gate defining openings overlying the drain/source regions and openings overlying the source/drain regions.

14. The integrated circuit of claim 13, further comprising an N channel transistor formed in and on the wafer.

15. The integrated circuit of claim 14, further comprising a P channel transistor formed in and on the wafer.

16. The integrated circuit of claim 13, further comprising a P channel transistor formed in and on the wafer.

17. A process for forming an integrated circuit, comprising the steps of:
forming a body region of a second conductivity type in a top surface of a semiconductor wafer of a first conductivity type, the body region encompassing a region of the first conductivity type;
forming a gate region overlying the body region, the gate region defining an opening overlying the body region and an opening overlying the region encompassed by the body region;
doping the wafer with dopants of the first conductivity type to form a drain/source region and a source/drain region, wherein the gate region acts as a mask that determines the location of the drain/source and source/drain regions, and the source/drain region is located in electrical contact with the region encompassed by the body region; and
forming a source/drain terminal on a bottom surface of the wafer.

18. The process of claim 17, further comprising:
forming an insulating layer overlying the gate region;
defining an opening in the insulting layer within an area overlying the drain/source region; and
forming a conducting layer over the insulating layer, wherein the conducting layer is partly disposed in the opening in the insulating layer and contacts the drain/source region.

19. The process of claim 18, further comprising:
forming in the top surface of the semiconductor wafer a contact region of the second conductivity type, wherein the contact region is in electrical contact with the body region and extends laterally beyond the gate region;
defining an opening in the insulting layer within an area overlying the contact region; and
patterning the conducting layer to form a first portion in electrical contact with drain/source regions and a second portion in electrical contact with the contact region, wherein the first and second portions are electrically isolated from each other.
